# EUROPEAN PATENT SPECIFICATION

(11) **EP 2 442 279 B1**
(45) Date of publication and mention of the grant of the patent: **09.01.2019**
(21) Application number: 10187387.5
(22) Date of filing: 13.10.2010
(51) Int. Cl.: G06T 17/30, G06F 17/50

(54) **Design optimization of physical bodies**
Designoptimierung von physikalischen Körpern
Optimisation de la conception de corps physiques

(43) Date of publication of application: 18.04.2012
(73) Proprietor: Honda Research Institute Europe GmbH, 63073 Offenbach/Main (DE)
(72) Inventor: Menzel, Stefan, Dr., 63303 Dreieich (DE)
(74) Representative: Rupp, Christian

(56) References cited:
- EP-A1- 1 840 842
- STEFAN MENZEL ET AL: "Direct Manipulation of Free Form Deformation in Evolutionary Design Optimisation", PARALLEL PROBLEM SOLVING FROM NATURE - PPSN IX LECTURE NOTES IN COMPUTER SCIENCE;;LNCS, SPRINGER, BERLIN, DE, vol. 4193, 1 January 2006 (2006-01-01), pages 352-361, XP019042690, ISBN: 978-3-540-38990-3
- MENZEL S ET AL: "Application of Free Form Deformation Techniques in Evolutionary Design Optimisation", INTERNET CITATION, 30 May 2005 (2005-05-30), XP002375170, Retrieved from the Internet: URL:http://www.wcsm06.org/papers/5161.pdf [retrieved on 2006-03-31]
- WAGNER ANDREAS: "Robustness and evolvability: a paradox resolved", PROCEEDINGS - ROYAL SOCIETY, BIOLOGICAL SCIENCES, ROYAL SOCIETY , LONDON, GB, vol. 275, no. 1630, 1 January 2008 (2008-01-01), pages 91-100, XP008134212, ISSN: 0962-8452

## Description

This invention is in the field of shape/design optimization of physical objects.

Design optimization of physical bodies or objects is a wide application area of high importance in various industrial fields.

The invention can be applied for all forms of problems involving the search for optimum design solutions using shape morphing techniques which rely on control point grids, e.g. design optimization of physical bodies for aerodynamic efficiency, design optimization of physical bodies for structure stability in a car crash scenario. Areas are automotive, aircraft, turbines, engines, outboard engines.

In the following, generally the terms shape and design are used interchangeably. The same holds for body/bodies and object/objects. The optimization of a physical object, as disclosed herein, relies on the optimization of its data representation.

In general, the success of the optimization is strongly dependent on an efficient interplay between representation (shape parameterization), optimizer (optimization algorithm) and evaluation method (design performance). With respect to design optimization, also called shape optimization or geometry optimization, it is important to select an adequate representation which provides a fair trade-off between design variability and the number of descriptive parameters. While standard engineering representations are often very compact, they are almost always incomplete in the sense that not all possible shapes can be represented.

Although e.g. NURBS as a prominent example for a shape representation are only complete if the representation is adaptive, their versatility is usually much higher. At the same time, the representation of complex shapes with many edges (like e.g. a whole turbine) requires a NURBS surface with a very large number of control points. However, the number of control points defines the dimension of the search space, i.e. the size of the domain of the function to be optimized. If the dimension of the search space is much larger than 200 and no subspaces can be easily identified to allow a sequential search, the shape design optimization process is prohibitively time consuming and the convergence may not be achieved [Menzel et al., 2008].

Free form deformation (FFD) techniques, which will be introduced in the following, are fundamentally different from other representations in that they do not represent the actual shape but changes to a baseline shape. Because of their ability to handle shapes of arbitrary complexity, they are becoming more widely used as an efficient object representation for a fully automated design optimization recently. Of course the changes that can be represented might be limited by the complexity of the representation [Menzel et al., 2008]. Additionally, FFD is especially attractive for the optimization of designs which provide structural inconsistencies like e.g. holes or sharp edges, and provides several advantages as the number of optimization parameters is, generally spoken, arbitrary, i.e. user dependent, and unfolds in combination with numerical methods which are required for the quantification of the design performance to a very powerful representation.

FFD has been introduced in the late 1980's in the field of computer graphics [Sederberg et al., 1986; Coquillart, 1990]. When applying FFD, the current state-of-the-art deformation algorithm, the object is embedded within a lattice of control points, which defines the degrees of freedom for the deformation. The parameter set and consequently the difficulty of the optimization problem can be tuned by the number and choice of control points or control point groups.

When defining the parameter set of an FFD system, an optimal trade-off between search space dimension and design flexibility, i.e. freedom of variation, has to be found. However, compared to spline based representations, in the FFD framework the complexity of design variations and not of the initial design is the limiting factor.

In case of problems that need finite element or finite volume methods for design evaluations like in computational fluid dynamics, FFD has another advantage [Perry et al., 2000; Menzel et al., 2005]. The fidelity of computational fluid dynamics (CFD) simulations depends to a large degree on the quality of the mesh or grid that is used for the simulation. For complex shapes and structures, mesh generation is a very time consuming process (several days), which more often than not requires manual fine-tuning or resolution of meshing problems. In particular, in the context of population based search methods like evolutionary algorithms, manual mesh generation is not feasible.

In the FFD framework, the mesh is deformed just like the design is deformed. Therefore, the mathematical deformation procedure is applied to the design and to the mesh simultaneously. This has the great advantage that mesh generation just has to be done once at the beginning of the optimization for the baseline design. During optimization the mesh is always adapted to the changing design. Of course, the quality of the deformed mesh has to be controlled during the search process. However, for complex shape design, the whole optimization process takes days and weeks and the sporadic analysis of the current mesh quality in parallel to the search process is feasible [Menzel et al., 2008].

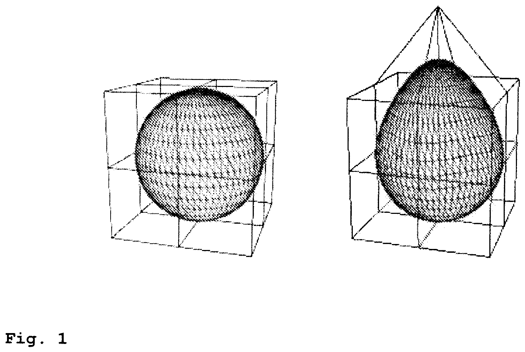

The basic idea behind FFD is depicted in **Fig. 1****.** The sphere represents the object which is the target of the optimization. It is embedded in a lattice of control points (CP). Firstly, the coordinates of the object have to be mapped to the coordinates in the spline parameter space. If the object is a surface point cloud of the design or a mesh which originates from an aerodynamic computer simulation, each grid point has to be converted into spline parameter space to allow the deformations. After this process of 'freezing', the object can be modified by moving a control point to a new position. The new control point positions are the inputs for the spline equations and the updated geometry is calculated. Since everything within the control volume is deformed, a grid from computational fluid dynamics that is attached to the shape is also adapted. Hence, the deformation affects not only the shape of the design but also the grid points of the computational mesh, which is needed for the CFD evaluations of the proposed designs. The new shape and the corresponding CFD mesh are generated at the same time without the need for an automated or manual re-meshing procedure. This feature significantly reduces the computational costs and allows a high degree of automation. Thus, by applying FFD the grid point coordinates are changed but the grid structure is kept [Menzel et al., 2008].

As already mentioned, the number and distribution of control points have to be chosen carefully. As one can imagine, an inappropriate set-up of the FFD control volume increases the necessary size of the parameter set and, therefore, the dimensionality of the search space. One of the reasons is that the impact of a control point on an object decreases when the distance from the object increases.

Even a small object variation requires a large modification of the control point if the initial distance between object and control point is large which also violates the strong causality condition that is important in particular for Evolution Strategies [Sendhoff et al., 1997]. This in turn often modifies other areas of the design space which has to be compensated for by the movement of other control points. Hence, often correlated mutations of control points are necessary for a local change of the object geometry [Menzel et al., 2008].

FFD is based on splines and relies on a grid of control points in which an initial base design is embedded.

This means, that a physical object is digitized using sensors, e.g. visual sensors. In the digitalization of the physical object, its spatial shape or design is detected to obtain a data representation of the object, e.g. in 3D coordinates. Afterwards, a grid is applied to the objects data representation and control points are defined through which the grid, and thereby the data representation of the object can be deformed or reshaped. In the design optimization process, single ones or groups of control points are modified to generate shape variations. As a consequence, the initial set-up of the control points influences strongly the performance of the optimization. Scientific publication "Direct Manipulation of Free Form Deformation in Evolutionary Design Optimization" by S. Menzel, M. Olhofer and B. Sendhoff, in: Parallel Problem Solving from Nature - PPSN IX Lecture Notes in Computer Science; LNCS, Springer, Berlin, DE, vol. 4193, 1 January 2006, pages 352-361, ISBN: 978-3-540-38990-3, discloses an optimization process of an initial design using a deformation technique based on a given control point setup. The disclosed method uses a given initial control point configuration designed manually during optimization. In general, the initial control volume is generated based on the experience of the engineer. In this invention, a computational method is suggested which allows the calculation of an initially optimal control point grid.

### Summary of the invention

The invention solves the problems posed with a method, program and system according to the independent claims. Further aspects of the invention are addressed by the dependent claims.

In one aspect, the invention provides a method for optimizing a shape of a physical object using a free-form deformation technique (FFD), the method comprising steps of:
- obtaining an initial data representation of the shape of the physical object, wherein the initial data representation comprises point coordinates obtained from a surface point cloud of the digitalized physical object or a mesh originating from an aerodynamic computer simulation,
- obtaining a reference data representation of the shape of the physical object, wherein the reference data representation comprises representative point coordinates (of the initial data representation,
- generating a grid of control points for the initial data representation by returning a control point configuration having the highest measure for structure robustness in a set of control point configurations, wherein for each possible control point configuration the measure for structure robustness evaluates the number of shape variants of the reference data representation, obtainable via free-form deformation starting from said control point grid configuration, which are similar to the reference data representation according to a threshold,
- optimizing the shape of the physical object by a shape morphing algorithm using the free form deformation technique based on the returned control point grid,
- returning the optimized shape for the physical object. The method is further characterized in that the measure for structure robustness for a control point configuration is calculated by determining representative control points of the initial control point grid,
by embedding the reference data representation into the control point grid by mapping each point coordinate of the reference data representation to a spline parameter space of the control point grid, modifying positions of the representative control points to obtain a plurality of modified control point configurations. For each modified control point configuration, a shape variant of the reference data representation is calculated by free-form deformation using the modified control point configuration to obtain an updated data representation. A similarity between the updated data representation and the reference data representation is calculated by calculating a shape distance in 3D coordinates of the updated and the initial data representation. The number of modified control point configurations for which the shape distance is smaller than the threshold as the value of the measure for structure robustness is returned.

The updated data representation can be compared to the reference data representation, e.g. by calculating the Euclidean distance.

Updated data representation variants may be generated by modifying control points and/or knot vector(s) of a control point configuration.

The generation/computation may be carried out by an optimization algorithm configured to generate an optimal control grid layout by maximizing the measure for structure robustness.

Additional constraints can be added for the generation/computation of the initially optimal control point configuration, wherein the additional constraints may be a predefined distance between control points.

The shape optimization of geometries can target at least one of an increase of aerodynamic/fluid dynamic efficiency of physical bodies, an increase of structure stability of physical bodies and a minimization of noise generated during the operation of physical bodies.

In another aspect, a computer software product, implementing a method as describe above when run on a computing device is provided.

In yet another aspect, a computer system adapted to perform a method as described above.

Further aspects of the invention will become apparent from the figures and the following description.

### Brief description of the drawings

**Fig. 1** shows a Free Form Deformation [Perry et al., 2000]. A design is embedded within a lattice/grid of control points. A modification of control points affects the shape as well as everything else inside the control volume.
**Fig. 2** shows an example for an optimization initialization and a generational cycle for an evolutionary design optimization of a turbine blade, taken from [Menzel et al., 2008].
**Figs. 3a****-c** show an example system set-up.
**Fig. 4** illustrates two results of an algorithm explained below for step iii c) for case a) P₁ₐ=7.5. Black dots mark if the distance is smaller than the predefined threshold. Left: x₂=1.1 and x₃=2.2, right: x₂=7.1 and x₃=8.2.
**Fig. 5** shows: left: E_{covol} for case a), black boxes mark the results for x₂=1.1, x₃=2.2 (Ecovol=4) and x₂=7.1, x₃=8.2 (Ecovol=16), right: Ecovol for case b) .
**Fig. 6** illustrates E_{covol} plotted for all Pᵢ.

### Detailed description of the invention

The present invention tackles the problem of efficiently and automatically setting up the FFD control volume.

To realize an automized set-up at first an adequate measure for the FFD control grid quality has to be defined. This measure is based on the concept of evolvability as proposed by [Wagner, 2008]. [Wagner, 2008] suggests a solution to the paradox of system robustness and evolvability by distinguishing between a genotype level, i.e. the encoding, representation or sequence, and a phenotype level, i.e. the system structure. For the present invention, the most important phrase is that high structure robustness means high structure evolvability. [Wagner, 2008] shows that for a biological system a representation which generates highly robust structures promotes evolvability. Hence, the idea of the present invention is to compute an optimal, in the sense of high structure robustness, FFD control point grid layout which is the basis for a follow-up search process. This computation requires two steps.

First, a quantification of the FFD control point grid quality which is realized in the present invention by measuring the structure robustness of design variants. By measuring structure robustness an evolvability measure *E_{covol}* is defined. Second, the evolvability measure *E_{covol}* is utilized to calculate efficient FFD control volumes, e.g. by a sampling method or an optimization algorithm.

The optimal control point grid set-up is characterized based on the evolvability measure for calculating structure robustness and called "Evolvable Control Volume Layout" (EcoVoL), which allows a quantification of the quality of control point grids. This measure, which is explained later in more detail, favors control point grids which allow an initially higher variability, prevent systems to get stuck in local optima especially for changing environments, and allow an efficient optimization by promoting neutral shape modifications. Hence, an application of evolvable control point grids increases strongly the efficiency of various real-world product optimizations.

The typical process of the design optimization of physical bodies/objects falls into several steps.

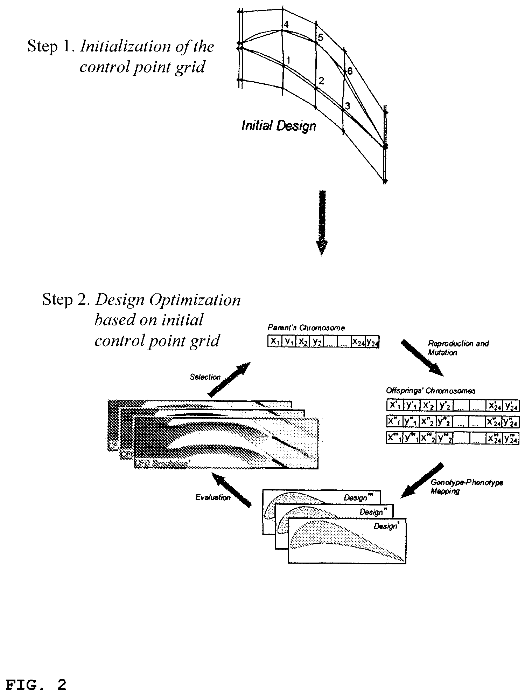

With respect to the present invention two steps are considered. The first step is the initial set-up of the representation and the second step comprises the optimization loop based on the initial representation. As an example, **Fig. 2** depicts both steps of this workflow for the exemplary design optimization of a turbine blade utilizing Free-Form Deformation (FFD), an evolutionary optimization algorithm and Computational Fluid Dynamics (CFD) for the aerodynamic simulation of design proposals.

The present invention focuses on step 1. The initialization of an adequate FFD control point grid is very important for a successful optimization. In general, the set-up is carried out by a human based on his/her expertise in the application field and spline mathematics. Nevertheless, since the control point grid is basically arbitrary the perfect choice of the number and distribution of control points and choice of knot vectors is very difficult.

The computation of an initially optimal control point grid layout for a design representation, which is the target of the invention, is optimal in the sense of providing an optimal starting point for the optimization and promoting the optimization process by increasing flexibility. Hence, the contribution of this invention is twofold:
The core of the invention is the formulation of a measure for structure robustness, which can also be called evolvability measure *E_{covol}*. Based on structure robustness, this measure quantifies the quality of a control point grid.

Further, based on this measure an optimization algorithm is applicable which adjusts the position and distribution of control points to maximize the structure robustness of the control point grid and, thus, allows an efficient optimization by promoting neutral shape modifications to overcome local optima.

For the deviation of the measure for structure robustness, or evolvability measure, a central characteristic for evolvable biological systems is taken as basis from [Wagner, 2008].

A biological system is defined on two levels, a genotype level which comprises the encoding, and a phenotype level which comprises the structure. For biological systems it is shown that high structural robustness that can be explored by mutations can generate high structural evolvability. The idea is that without affecting the primary function of the organism (neutral mutation), secondary properties can be changed.

In the present invention, this characteristic is combined with control point grids of Free-Form Deformation (FFD) systems promoting highly efficient system set-ups. To quantify the quality of an FFD control volume the structure robustness is calculated and assigned as evolvability measure *E_{covol}*.

As already stated above, from technical perspective, FFD control volumes are currently designed manually and rely heavily on the experience of the designer. In contrast, the evolvability measure *E_{covol}* allows a quantification of the evolvability of a designed FFD control volume and, as a consequence, an application of a computational optimization based on *E_{covol}* in a fully automated process to search for an initially optimal control point grid layout. A major advantage of the inventive method is that it is possible to compute the control grid layout based on the current state of the design representation, i.e. without any need to modify the design representation and to estimate possible effects on the design performance.

Additionally, it is also detectable that the follow-up optimization process (step 2) strongly profits from control point grid layouts based on a high *E_{covol}* because the small distance between the control point settings which generate the neutral design modifications, and thus structure robustness, allow a stepwise movement between these control point settings. These stepwise neutral movements imply that it is possible to evade local optima during the optimization process. A generalization of the concept of structure robustness to splines seems also possible.

The impact of this invention is strongly connected to the quantification of the quality of a control point grid layout as a pre-processing step to a subsequent adaptation of the control points and/or knot vector(s).

The quantification is required for the application of a sampling or an optimization algorithm which solves the task of generating an optimal control point grid layout.

As explained above, to quantify a control volume the concept of evolvability is applied. The evolvability is measured utilizing the concept of structure robustness. A reference design *D_{R}* is represented using a base design consisting of points *Pᵢ* and a base control volume, an evolvable system with respect to this invention is characterized by a high number of control point variations which in turn produce designs similar to the reference design, i.e. points *Pᵢ*^{*} which are in a close neighborhood to *Pᵢ*.

Hence, the larger the amount of similar designs, which are producible by a representation, the higher the evolvability of the system. The different control point configurations that represent one and the same shape must be reachable during the second step of control point optimization or manipulation in general. In FFD representation, due to the special constraints in the control point grid imposed by the continuous character of the underlying splines, it can be assumed that the different configurations are connected in the sense that small changes will lead to a new neutral configuration. Therefore, in the space of all possible control grid configurations, those that result in the same shape are connected and accessible by small changes in the configuration parameters.

Practically, a base control point grid is generated, e.g. manually or by an optimization algorithm. This grid consists of a distribution of control points. Next, a base geometry *D_{R}* is embedded within the control point grid and representative points *Pᵢ* on the design are chosen, e.g. manually or based on prior data analysis of the design.

These points *Pᵢ* are transferred to a spline parameter space of the FFD control grid, e.g. by the FFD freezing algorithm. To measure the structure robustness the control grid is modified in such a way that the control points are moved to *all possible* control point positions, usually carried out by using a discretization value.

For each modified control point position the coordinates of the design points *Pᵢ* are updated to *Pᵢ^{*}* and compared to the initial coordinates of the reference design, e.g. by calculating the Euclidean distance between *Pᵢ* and *Pᵢ*^{*}. If the distance is smaller than a defined threshold the evolvability measure *E_{covol}* is increased by one. As a result, *E_{covol}* evaluates the occurrence of similar designs which are representable by a control point grid and hence, quantifies its quality. The process is explained in the following for a simplified system. The extension to more dimensions and different spline types is nevertheless straightforward.

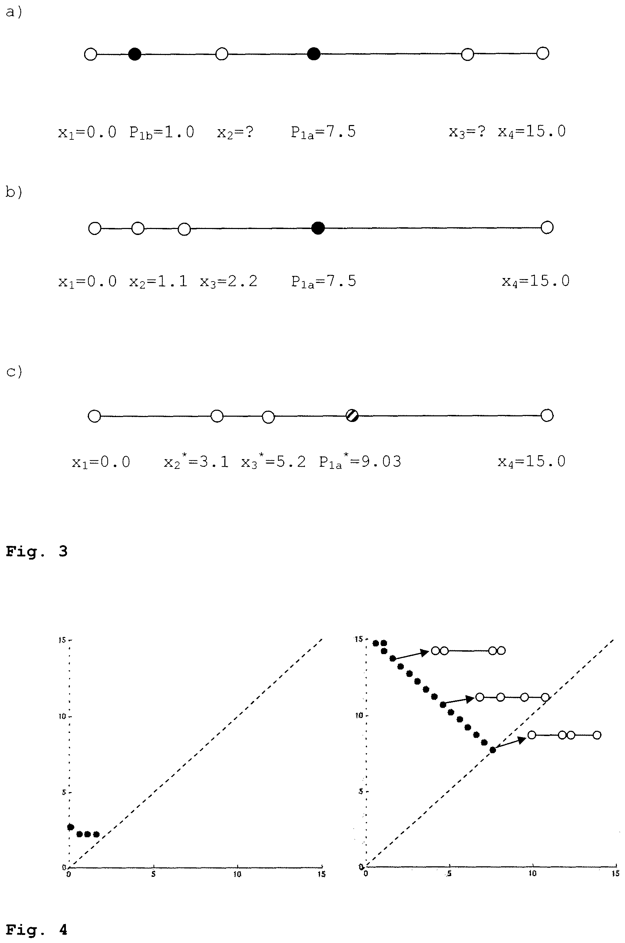

An example system as shown in **Fig. 3a** is one-dimensional and consists of a control point grid with 4 control points. The underlying spline is a state-of-the-art NURBS of order 4, i.e. degree 3, and the knot vector is chosen to [0,0,0,0,1,1,1,1] for a clamped spline. As reference geometry exactly one point P₁ is chosen. The FFD grid is defined by 4 points. The first one is positioned fix at x₁=0.0. The fourth one is positioned fix at x₄=15.0. In case a) the point P₁ₐ is chosen to 7.5 and in case b) the point P_{1b} is chosen to 1.0. The task is to find the optimal positions of x₂ and x₃ which provide the highest system evolvability.

An *algorithm as shown below provides an overview on the calculation of E_{covol}* of case a) for one possible control point grid, i.e. x₂ and x₃ are chosen from possible positions in the interval [0,15]. In the algorithm, x₂ is exemplary set to 1.1 and x₃ to 2.2. For these chosen positions, P₁ₐ is frozen. Next, x₂ and x₃ are stepwise moved in x-direction to all possible positions in the interval [0,15] and P₁ₐ is updated to P₁ₐ^{*}. The Euclidean distance is calculated between the updated positions P₁ₐ^{*} and initial positions P₁ₐ. If the distance is small enough, the evolvability measure *E_{covol}* is increased by one. Pseudocode is given in the algorithm for case a).

| Algorithm in Pseudocode for calculating *E_{covol}.* Example for case a) P₁ₐ = 7.5 | |
|---|---|
| i) | Set x₂ and x₃ within [0,15]: |
| | An Exemplary set-up is shown for x₂=1.1 and x₃=2.2 in **Fig. 3b**. |
| ii) | Freeze P₁ₐ: |
| | Exemplary frozen spline parameter u₁ₐ=0.7538. |
| iii) | Loop 1: |
| | For all possible control point positions x₂^{*} and x₃^{*} in [0,15] do |
| | a) Set x₂^{*} and x₃^{*}: An Exemplary modification of control points is shown for x₂^{*}=3.1 and x₃^{*}=5.2 in **Fig 3c**. |
| | b) Calculate deformation: Update P₁ₐ^{*} using modified control points x₂^{*} and x₃^{*}. |
| | c) *If* \|*P₁ₐ*^{*} - *P₁ₐ*\| < *ε. than E_{covol}* = *E_{covol}* +1 |
| iv) | End Loop 1: Assign *E_{covol}* to control grid set-up. |

The result of the algorithm, step iii) c), is exemplary depicted in **Fig. 4****.** A black dot marks a control point setting where the Euclidean distance between P₁ₐ^{*} and P₁ₐ is smaller than ε (here: ε chosen to 0.1) and which, thus, increases the structure robustness.

The x-axis reflects the position of x₂ and the y-axis reflects the position of x₃. As two side remarks: First, only the upper triangle has been calculated because of the symmetry of the system, i.e. x₂<x₃. Second, the discretization for the scatter plot has been chosen to 0.5.

*E_{covol}* is calculated by summing up all control point settings which provide structure robustness. For x₂=1.1 and x₃=2.2, *E_{covol}* equals 4. For x₂=7.1 and x₃=8.2, *E_{covol}* equals 16. Thus, the choice of x₂=7.1 and x₃=8.2 provides a higher structure robustness and defines a favorable control point grid layout.

As it is visible in **Fig. 4**, the positions of control points which generate robust structures are close connected. If the value of the discretization would be lowered (→0) the dots would get closer and closer. This additional feature is very valuable for an optimization which relies on a control volume with a high structure robustness. During the optimization it is possible that modifications are carried out on the control points which still produce similar designs and, thus, similar design performances. As a consequence, the probability to get stuck in local optima is decreased for control point grids which provide a high structure robustness.

To summarize, so far the algorithm outlined above calculates for one chosen control grid set-up the measure for structure robustness *E_{covol}* which defines the degree of evolvability. Based on this measure it is possible to find the optimal control point grid set-up, i.e. the control point grid which provides the highest degree of evolvability. This can be e.g. done by testing all possible control point grid set-ups or, for larger control grids, by utilizing an optimization algorithm.

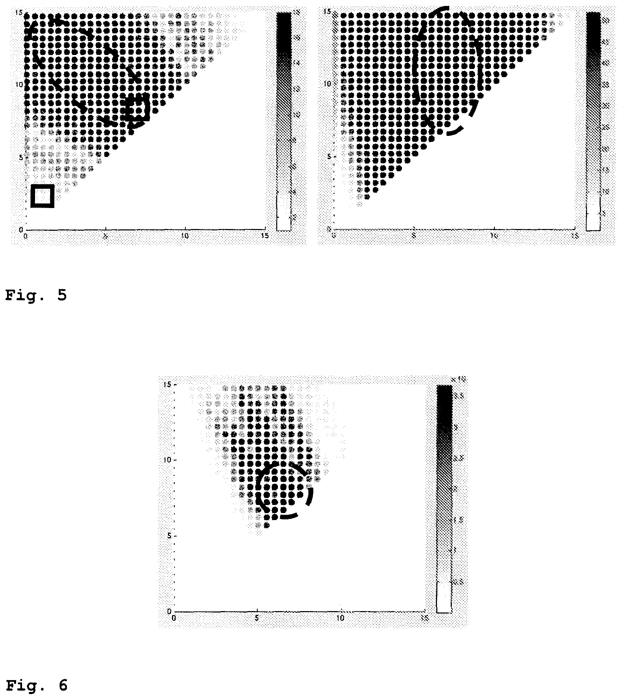

For the present example all possible control point grids are taken into account (discretization: 0.5). For each grid the algorithm is carried out. The results for a) and b) are depicted in Figure 5. The results for the choice of x2=1.1 and x3=2.2 (*E_{covol}*=4), as well as x2=7.1 and x3=8.2 (*E*_{*covol*=}16) are marked by boxes.

The plots depicted in **Fig. 5** present an overview on the evolvability measure *E_{covol}* for case a) and case b) for all possible control point grids. On the x-axis x₂ is plotted, on the y-axis x₃ is plotted. The color mark the *E_{covol}*, a darker color indicates a higher robustness and, thus, a higher evolvability. The regions which provide the highest evolvability are marked. As it can be seen, there are several possibilities to achieve a high evolvability for the given points Pᵢ, e.g. for case a) x₂=7.1 and x₃=8.2 is favorable over x₂=1.1 and x₃=2.2. In contrast, for case b) e.g. x₂=8.0 and x₃=12.0 is a good solution.

For completeness, in a follow-up experiment shown in **Fig. 6**, the point Pᵢ has been varied using in ascending order a value from [0.25,0.5,1,2,3,4,5,6,7,7.5]. For each Pᵢ the evolvability measure *E_{covol}* has been calculated and plotted according to **Fig. 5**. To find the optimal control volume which provides a high evolvability for all Pi, the evolvability measures within all plots has been multiplied and the resulting plot is depicted in **Fig. 6. Fig. 6** shows that there exists a region with different control point positions which provide a highly evolvable control point grid.

Alternatively, it is possible to carry out the search for a highly evolvable control point grid using an optimization algorithm. This becomes especially important for a larger number of control points. The method to calculate combinatorial all possible control point set-ups is not feasible anymore. Using an optimization algorithm allows the maximization of *E_{covol}* and provides the optimal control point grid layout. Additionally, an optimization allows the integration of additional constraints, e.g. a minimum distance between control points or further constraints on control points.

The present invention therefore provides two important parts. First, it is possible to calculate the structure robustness to quantify the quality of a control point grid. Second, it is possible to carry out an optimization of the control point grid layout using the structure robustness as performance indicator.

### Glossary

*Structure robustness*: A measure that specifies the quantity and relation between control point configurations that represent identical shapes in the context of shape morphing algorithms.

### References

Coquillart, S. (1990). "Extended Free-Form Deformation: A Sculpturing Tool for 3D Geometric Modeling." Computer Graphics, 24(4):187-196.
Menzel, S., Sendhoff, B. (2008). "Representing the Change - Free Form Deformation for Evolutionary Design Optimization." Tina Yu et al. (eds.), Evolutionary Computation in Practice, Springer Berlin/Heidelberg, pp. 63-86.
Menzel, S., Olhofer, M., Sendhoff, B. (2005). "Evolutionary Design Optimisation of Complex Systems integrating Fluent for parallel Flow Evaluation." In: Proceedings of European Automotive CFD Conference, pp. 279-289.
Perry, E.C., Benzley, S.E., Landon, M., Johnson, R. (2000). "Shape Optimization of Fluid Flow Systems." In: Proceedings of ASME FEDSM'00. ASME Fluids Engineering Summer Conference, Boston.
Sederberg, T.W., Parry, S.R. (1986). "Free-Form Deformation of Solid Geometric Models." Computer Graphics, 20 (4) :151-160.
Sendhoff, B., Kreuz, M., and von Seelen, W. (1997). A condition for the genotype-phenotype mapping: Causality. In: Thomas Bäck, editor, Proceedings of the Seventh International Conference on Genetic Algorithms (ICGA'97), Morgan Kauffmann, pp. 73-80.
Wagner, A. (2008). "Robustness and evolvability: a paradox resolved." Proc. R. Soc. B, 275, pp. 91-100.

## Claims

1. A method for optimizing a shape of a physical object using a free-form deformation technique (FFD), the method comprising the steps of:
- obtaining an initial data representation of the shape of the physical object, wherein the initial data representation comprises point coordinates obtained from a surface point cloud of the digitalized physical object or a mesh originating from an aerodynamic computer simulation,
- obtaining a reference data representation of the shape of the physical object, wherein the reference data representation comprises representative point coordinates (Pᵢ) of the initial data representation,
- generating a grid of control points for the initial data representation by returning a control point configuration having the highest measure for structure robustness (E_{COVOL}) in a set of control point configurations,
- optimizing the shape of the physical object by a shape morphing algorithm using the free-form deformation technique based on the returned control point grid,
- returning a data representation of the optimized shape for the physical object, and wherein the measure for structure robustness (E_{COVOL}) for a control point configuration (x₁, x₂, x₃, x₄) is calculated by determining representative control points (x₂, x₃) of the initial control point grid, embedding the reference data representation into the control point grid by mapping each point coordinate (P₁) of the reference data representation to a spline parameter space of the control point grid, modifying positions of the representative control points (x₂, x₃) to obtain a plurality of modified control point configurations, for each modified control point configuration, calculating a shape variant of the reference data representation (P₁ₐ) by free-form deformation using the modified control point configuration to obtain an updated data representation (P_{1a*}), and determining a similarity between the updated data representation (P_{1a*}) and the reference data representation (P₁ₐ) by calculating a distance of point coordinates of the updated and the initial data representation, and returning the number of modified control point configurations for which the distance is smaller than the threshold (ε) as the value of the measure for structure robustness (E_{COVOL}).

2. The method according to claim 1,
wherein the updated data representation (P_{1a*}) is compared to the reference data representation (P₁ₐ) by calculating the Euclidean distance.

3. The method according to any one of the preceding claims,
wherein updated data representation variants (P_{1a*}) are generated by modifying control points and/or knot vector(s) of a control point configuration.

4. The method according to any one of the preceding claims,
wherein the generation is carried out by a scan of a subset of all possible control point positions (x₁, x₂, x₃, x₄) within the control point grid.

5. The method according to any one of the preceding claims,
wherein additional constraints on control points (x₁, x₂, x₃, x₄) are added for the generation of the control point grid
wherein the additional constraints are a predefined distance between control points (x₁, x₂, x₃, x₄).

6. The method according to any one of the preceding claims,
wherein the shape optimization of the physical object targets at least one of an increase of aerodynamic/fluid dynamic efficiency of the physical object, an increase of structure stability of physical object and a minimization of noise generated during the operation of the physical object.

7. A computer software product, implementing any one of the preceding claims 1 to 9 when run on a computing device.

8. A computer system adapted to perform a method according to any one of the claims 1 to 6.

## Patentansprüche

1. Verfahren zur Optimierung einer Form eines physikalischen Objekts unter Verwendung einer Freiformverformungstechnik (FFD), wobei das Verfahren die folgenden Schritte aufweist:
- Gewinnen einer anfänglichen Datendarstellung der Form des physikalischen Objekts, wobei die anfängliche Datendarstellung Punktkoordinaten, die von einer Oberflächenpunktwolke des digitalisierten physikalischen Objekts gewonnen werden, oder ein Netz, das aus einer aerodynamischen Computersimulation stammt, aufweist,
- Gewinnen einer Referenzdatendarstellung der Form des physikalischen Objekts, wobei die Referenzdatendarstellung darstellende Punktkoordinaten (Pᵢ) der anfänglichen Datendarstellung aufweist,
- Erzeugen eines Gitters aus Steuerpunkten für die anfängliche Datendarstellung durch Zurückgeben einer Steuerpunktkonfiguration mit dem höchsten Maß für die Strukturrobustheit (E_{COVOL}) in einem Satz von Steuerpunktkonfigurationen,
- Optimieren der Form des physikalischen Objekts durch einen Formgestaltungsalgorithmus unter Verwendung der Freiformverformungstechnik basierend auf dem zurückgegebenen Steuerpunktgitter,
- Zurückgeben einer Datendarstellung der optimierten Form für das physikalische Objekt und wobei das Maß für die Strukturrobustheit (E_{COVOL}) für eine Steuerpunktkonfiguration (x₁, x₂, x₃, x₄) durch Bestimmen jeweiliger Steuerpunkte (x₂, x₃) des anfänglichen Steuerpunktgitters berechnet wird,
- Einbetten der Referenzdatendarstellung in das Steuerpunktgitter durch Abbilden jeder Punktkoordinate (P₁) der Referenzdatendarstellung auf einen Spline-Parameterraum des Steuerpunktgitters,
- Modifizieren von Positionen der darstellenden Steuerpunkte (x₂, x₃), um eine Vielzahl modifizierter Steuerpunktkonfigurationen zu gewinnen,
- für jede berechnete Steuerpunktkonfiguration Berechnen einer Formvariante der Referenzdatendarstellung (P₁ₐ) durch Freiformverformung unter Verwendung der modifizierten Steuerpunkkonfiguration, um eine aktualisierte Datendarstellung (P_{1a*}) zu gewinnen, und Bestimmen einer Ähnlichkeit zwischen der aktualisierten Datendarstellung (P_{1a*}) und der Referenzdatendarstellung (P₁ₐ) durch Berechnen eines Abstands von Punktkoordinaten der aktualisierten und der anfänglichen Datendarstellung und Zurückgeben der Anzahl modifizierter Steuerpunktkonfigurationen, für die der Abstand kleiner als der Schwellwert (ε) ist, als den Wert für das Maß der Strukturrobustheit (E_{COVOL}).

2. Verfahren nach Anspruch 1,
wobei die aktualisierte Datendarstellung (P_{1a*}) mit der Referenzdatendarstellung (P₁ₐ) verglichen wird, indem der euklidische Abstand berechnet wird.

3. Verfahren nach einem der vorhergehenden Ansprüche,
wobei die aktualisierten Datendarstellungsvarianten (P_{1a*}) durch Modifizieren von Steuerpunkten und/oder Knotenvektor(en) einer Steuerpunktkonfiguration erzeugt werden.

4. Verfahren nach einem der vorhergehenden Ansprüche,
wobei die Erzeugung durch ein Abtasten einer Teilmenge aller möglichen Steuerpunktpositionen (x₁, x₂, x₃, x₄) innerhalb des Steuerpunktgitters ausgeführt wird.

5. Verfahren nach einem der vorhergehenden Ansprüche,
wobei für die Erzeugung des Steuerpunktgitters zusätzliche Nebenbedingungen für Steuerpunkte (x₁, x₂, x₃, x₄) hinzugefügt werden,
wobei die zusätzlichen Nebenbedingungen ein vordefinierter Abstand zwischen Steuerpunkten (x₁, x₂, x₃, x₄) sind.

6. Verfahren nach einem der vorhergehenden Ansprüche,
wobei die Formoptimierung des physikalischen Objekts auf wenigstens eines der Folgenden abzielt: eine Erhöhung der aerodynamischen/fluiddynamischen Effizienz des physikalischen Objekts, eine Erhöhung der Strukturstabilität des physikalischen Objekts und eine Minimierung von Geräuschen, die während des Betriebs des physikalischen Objekts erzeugt werden.

7. Computersoftwareprodukt, das einen der vorhergehenden Ansprüche 1 bis 9 implementiert, wenn es auf einer Computervorrichtung läuft.

8. Computersystem, das geeignet ist, ein Verfahren nach einem der Ansprüche 1 bis 6 durchzuführen.

## Revendications

1. Procédé pour optimiser une forme d'un objet physique en utilisant une technique de déformation de forme libre (FFD), le procédé comprenant les étapes consistant à :
- obtenir une représentation de données initiale de la forme de l'objet physique, dans lequel la représentation de données initiale comprend des coordonnées de points obtenues à partir d'un nuage de points de surface de l'objet physique numérisé ou d'une maille provenant d'une simulation d'ordinateur aérodynamique,
- obtenir une représentation de données de référence de la forme de l'objet physique, dans lequel la représentation de données de référence comprend des coordonnées de points représentatives (Pᵢ) de la représentation de données initiale,
- générer une grille de points de contrôle pour la représentation de données initiale en renvoyant une configuration de points de contrôle présentant la mesure la plus élevée pour la robustesse de structure (E_{COVOL}) dans un jeu de configurations de points de contrôle,
- optimiser la forme de l'objet physique par un algorithme de morphage de forme en utilisant la technique de déformation de forme libre sur la base de la grille de points de contrôle renvoyée,
- renvoyer une représentation de données de la forme optimisée pour l'objet physique, et
dans lequel la mesure pour la robustesse de structure (E_{COVOL}) pour une configuration de points de contrôle (x₁, x₂, x₃, x₄) est calculée :
en déterminant des points de contrôle représentatifs (x₂, x₃) de la grille de points de contrôle initiale,
en intégrant la représentation de données de référence dans la grille de points de contrôle en mettant en correspondance chaque coordonnée de point (Pₗ) de la représentation de données de référence sur un espace de paramètre spline de la grille de points de contrôle,
en modifiant des positions des points de contrôle représentatifs (x₂, x₃) pour obtenir une pluralité de configurations de points de contrôle modifiées,
pour chaque configuration de points de contrôle modifiée, en calculant une variante de forme de la représentation de données de référence (P₁ₐ) par déformation de forme libre en utilisant la configuration de points de contrôle modifiée pour obtenir une représentation de données mise à jour (P_{1a*}) et en déterminant une similarité entre la représentation de données mise à jour (P_{1a*}) et la représentation de données de référence (P₁ₐ) en calculant une distance de coordonnées de points des représentations de données mise à jour et initiale, et en renvoyant le nombre de configurations de points de contrôle modifiées pour lesquelles la distance est inférieure au seuil (ε) en tant que valeur de la mesure pour la robustesse de structure (E_{COVOL}).

2. Procédé selon la revendication 1,
dans lequel la représentation de données mise à jour (P_{1a*}) est comparée à la représentation de données de référence (P₁ₐ) en calculant la distance euclidienne.

3. Procédé selon l'une quelconque des revendications précédentes,
dans lequel des variantes de représentation de données mise à jour (P_{1a*}) sont générées en modifiant des points de contrôle et/ou un ou des vecteur(s) de noeud d'une configuration de points de contrôle.

4. Procédé selon l'une quelconque des revendications précédentes,
dans lequel la génération est réalisée par un balayage d'un sous-jeu de toutes les positions de points de contrôle possibles (x₁, x₂, x₃, x₄) à l'intérieur de la grille de points de contrôle.

5. Procédé selon l'une quelconque des revendications précédentes,
dans lequel des contraintes supplémentaires sur des points de contrôle (x₁, x₂, x₃, x₄) sont ajoutées pour la génération de la grille de points de contrôle,
dans lequel les contraintes supplémentaires sont une distance prédéfinie entre des points de contrôle (x₁, x₂, x₃, x₄).

6. Procédé selon l'une quelconque des revendications précédentes,
dans lequel l'optimisation de forme de l'objet physique cible au moins l'une parmi une augmentation de rendement aérodynamique/dynamique des fluides de l'objet physique, une augmentation de stabilité de structure d'objet physique et une minimisation de bruit généré durant le fonctionnement de l'objet physique.

7. Produit logiciel d'ordinateur, implémentant l'une quelconque des revendications précédentes 1 à 9 lorsqu'il est exécuté sur un dispositif informatique.

8. Système d'ordinateur adapté pour réaliser un procédé selon l'une quelconque des revendications 1 à 6.
